# EUROPEAN PATENT APPLICATION

(11) **EP 2 256 812 A1**
(43) Date of publication of application: **01.12.2010**
(21) Application number: 09160997.4
(22) Date of filing: 25.05.2009
(51) Int. Cl.: H01L 27/15, H01L 25/16, H01L 33/00, G02B 3/08

(54) **Semiconductor device for increasing output power of a light emitting unit**

(71) Applicant: NXP B.V., 5656 AG Eindhoven (NL)
(72) Inventor: Kuindersma, Piet, 5656 AE Eindhoven (NL); Kramer, Mark Cornelia Johannes Carolus Maria, 5656 AE Eindhoven (NL); Madakasira, Vijayaraghavan, 5656 AE Eindhoven (NL)
(74) Representative: Schouten, Marcus Maria

(57) **Abstract**

The invention relates to a semiconductor device for increasing output power of a light emitting unit, comprising: a substrate (2), a first layer arranged at a front-end of the semiconductor device, a second layer arranged at a back-end of the semiconductor device, and a Fresnel lens (3) arranged between the first layer and the second layer. In this way, the output power of a light emitting unit is enhanced and the planarity of semiconductor wafers is maintained.

## Description

### FIELD OF THE INVENTION

The invention relates to the field of semiconductor devices for increasing output power of a light emitting unit, preferably adapted for enhancing output power of a silicon light emitting unit as well as to methods of making and using such devices.

### BACKGROUND OF THE INVENTION

It is generally known that the design of a Fresnel lens enables the construction of lenses of large aperture and short focal length without the weight and volume of material being required in a conventional lens design. Compared to other lenses, the Fresnel lens is thinner and thus passes more light.

The Fresnel lens reduces the amount of material required compared to a conventional spherical lens by breaking the lens into a set of concentric annular sections known as Fresnel zones. In the first variations of the Fresnel lens, each of these zones has been a different prism. Although a Fresnel lens might look like a single piece of glass, closer examination reveals that it comprises a plurality of small pieces. For each of the Fresnel zones, the thickness of the Fresnel lens is decreased, effectively chopping the continuous surface of a standard lens into a set of surfaces of the same curvature comprising discontinuities between them. This allows a substantial reduction in thickness and thus a reduction in weight and in volume of the material of the Fresnel lens. However, a problem known is that this is done at the expense of reducing the imaging quality of the Fresnel lens. To sum up, Fresnel lenses have been used in applications where imaging quality is not critical or where the bulk of a solid lens would be prohibitive.

The light output power of a planar silicon light emitting unit is merely a small fraction of the internally generated light power. This small fraction approximately lies in the range between 1 to 2 % or even less in a practical numerical aperture (NA) of < 1. This is due to the almost total internal reflection at the silicon-air or the silicon-dioxide interface associated with the high refractive index of silicon.

However, there is the need to improve the light output efficiency of a light emitting unit, such as the light output efficiency of a light emitting diode, preferably of a silicon light emitting unit, and/or of an organic light emitting diode. The improvement of light output efficiency corresponds to increasing and enhancing, respectively, the light output power.

### SUMMARY OF THE INVENTION

It is the object of the invention to provide semiconductor devices, and methods of making and using the same, with a good output power of a light emitting unit, preferably adapted for enhancing output power of a silicon light emitting unit. An advantage of the present invention is to provide an improved light output efficiency of a light emitting unit.

This object is achieved by a semiconductor device for increasing output power of a light emitting unit. The semiconductor device comprises: a substrate, a first layer arranged at a front-end of the semiconductor device, a second layer arranged at a back-end of the semiconductor device, and a Fresnel lens arranged between the first layer and the second layer.

In other words, a complementary metal-oxide-semiconductor (CMOS) Fresnel lens that is located at an interface between the front-end and the back-end of the semiconductor device is introduced. According to an aspect of the invention, the incorporation of a CMOS Fresnel lens at the interface between front-end and back-end of a light emitting unit significantly increases the output power of the light emitting unit, which is most preferably a silicon light emitting unit, and thus enhances its light output efficiency. Inserting a thin Fresnel lens in a CMOS structure, the planarity of a semiconductor wafer, such as a silicon wafer, is maintained.

According to a preferred embodiment of the invention, the light emitting unit corresponds to one of a light emitting diode and an organic light emitting diode. As known to the skilled person both light sources emit incoherent light. However, the inventive idea is also applicable in combination with coherent light sources.

According to another preferred embodiment of the invention, the first layer of the semiconductor device comprises a silicon layer and the second layer of the semiconductor device comprises a silicon dioxide layer. The Fresnel lens preferably comprises a thickness of ≤ 2 µm, most preferably a thickness of ≤ 1 µm.

According to yet another preferred embodiment of the invention, the Fresnel lens comprises a layer of a first material and a layer of a second material. Preferably, the layer of the first material comprises a first refractive index and corresponds to at least one silicon layer, most preferably to at least one polysilicon layer. The layer of the second material preferably comprises a second refractive index being different from the first refractive index of the layer of the first material. At least one of the silicon layer and the polysilicon layer being preferably comprised by the layer of the first material is adapted for providing a gate region of a CMOS structure.

According to yet another preferred embodiment of the invention, the semiconductor device further comprises outside spacers arranged adjacent to the gate region of a CMOS structure comprised by the Fresnel lens. The semiconductor device preferably further comprises source and drain implants providing source and drain regions of a CMOS structure comprised by the Fresnel lens. The layer of the second material preferably corresponds to an insulating layer provided as a shallow trench isolation (STI) layer.

According to yet another preferred embodiment of the invention, the semiconductor device further comprises at least a second lens different from the Fresnel lens and arranged next to an interface between the back-end of the semiconductor device and an output of the light emitting unit. The output of the light emitting unit preferably comprises a medium comprising a material of at least one of air and silicon dioxide. Most preferably, the second lens corresponds to a second Fresnel lens being adapted for focusing an output beam of the light emitting unit.

Finally, it is worth mentioning that the inventive idea is applicable in standard CMOS layers to build a Fresnel lens at the interface between front-end and back-end of a semiconductor device. A most preferred application is a CMOS flash memory with its control and access gates in combination with an STI region to form the Fresnel lens. In such an application a stack of at least two polysilicon gate layers can be applied. With the semiconductor device comprising such a Fresnel lens, it becomes also possible to use the invention in imaging applications with improved imaging quality.

### BRIEF DESCRIPTION OF THE DRAWINGS

These and other aspects of the invention will be apparent from and elucidated with reference to the embodiments described hereinafter.

In the drawings:
Fig. 1 depicts a schematic cross section of a CMOS Fresnel lens according to an embodiment of the invention;
Fig. 2 depicts a more detailed view according to the embodiment of Fig. 1;
Fig. 3 illustrates the magnification as a function of the relative curvature for a silicon-silicon dioxide interfacial Fresnel lens according to another embodiment of the invention;
Fig. 4 depicts cross sections of three distinct CMOS Fresnel lenses according to another embodiment of the invention; and
Fig. 5 shows a schematic representation of a CMOS flash memory according to yet another embodiment of the invention.

### DETAILED DESCRIPTION OF EMBODIMENTS

In the following detailed description of the preferred embodiments, reference is made to the accompanying drawings, which form a part hereof, and within which are shown by way of illustration specific embodiments by which the invention may be practiced. The drawings described are only schematic and are nonlimiting. In the drawings, the size of some of the elements may be exaggerated and not drawn on scale for illustrative purposes. Those skilled in the art will recognize that other embodiments may be utilized and structural changes may be made without departing from the scope of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

In embodiments of the present invention, semiconductor devices are described which have a substrate. The term "substrate" may include any underlying material or materials that may be used, or upon which a device, a circuit or an epitaxial layer may be formed. The present invention is based on silicon containing semiconductor devices such as doped silicon, high-ohmic silicon, or a silicon germanium (SiGe) and especially those made by a CMOS process. However, in other alternative embodiments, this "substrate" may include a semiconductor substrate 1 such as e.g glass, aluminium oxide (Al₂O₃), a gallium arsenide (GaAs), a gallium arsenide phosphate (GaAsP), a germanium (Ge) substrate. The "substrate" may include, for example, an insulating layer such as a SiO₂ or a Si₃N₄ layer in addition to a semiconductor substrate portion. Thus, the term "substrate" also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer. The following processing steps are mainly described with reference to silicon processing but the skilled person will appreciate that the present invention may be implemented based on other semiconductor material systems and that the skilled person can select suitable materials as equivalence of the dielectric and conductive materials described below.

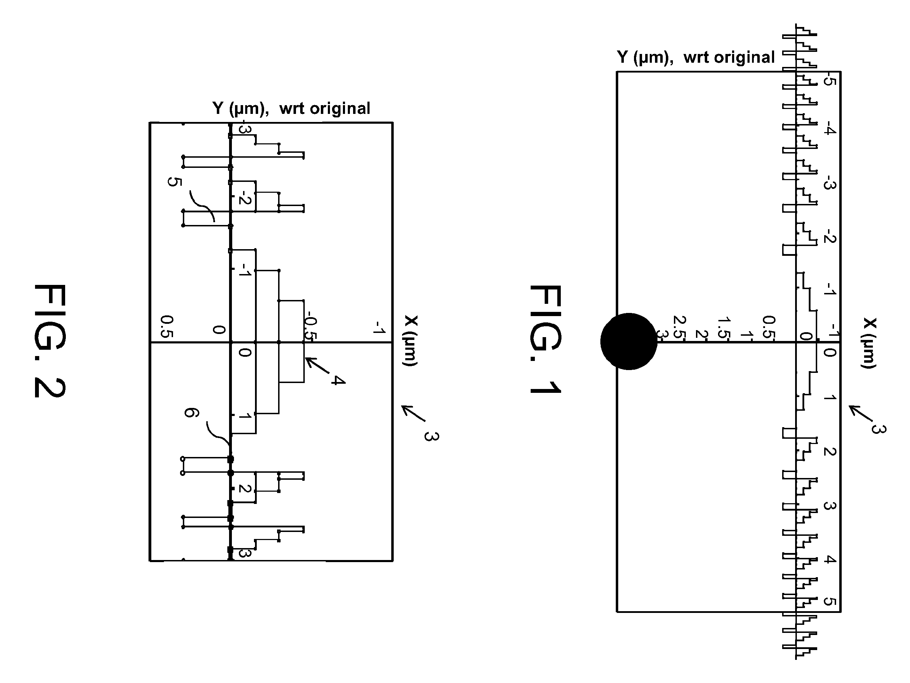

Fig. 1 shows a schematic cross section of a CMOS Fresnel lens 3 according to an embodiment of the invention. The Fresnel lens 3 is located at an interface between the front-end and the back-end of the semiconductor device. The Fresnel lens 3 is of parabolic type and comprises a triple gate polysilicon stack and an STI region or STI layer, respectively. The refractive indices n₁ and n₂ amount to 3.5 and 1.5, respectively. The spot of the output beam from the light emitting unit is located at about 3.75 µm distance. Further, in this embodiment the relative curvature B amounts to 1.75.

A more detailed view of the embodiment of Fig. 1 is shown in Fig. 2. Fig. 2 depicts an arrangement of a stack of three polysilicon layers 4, utilized as gate regions of a CMOS structure, and an STI layer in the central portion of the Fresnel lens 3. Outside spacers comprised by the gate region are not shown. Furthermore, the STI region 5 (or STI layer) and source and drain implants 6 providing the source and drain regions of the CMOS structure are shown. Using standard CMOS processes these source and drain implants 6 are obtained.

One function of the CMOS Fresnel lens 3 is to increase the output power of a light emitting unit. In this embodiment the almost total internal reflection inherent to an optical waveguide is decreased or almost suppressed and thus the light output efficiency is enhanced. Another function of the CMOS Fresnel lens 3 lies in an imaging application, i.e. to make an image of a light emitting spot in the silicon (light emitting) unit.

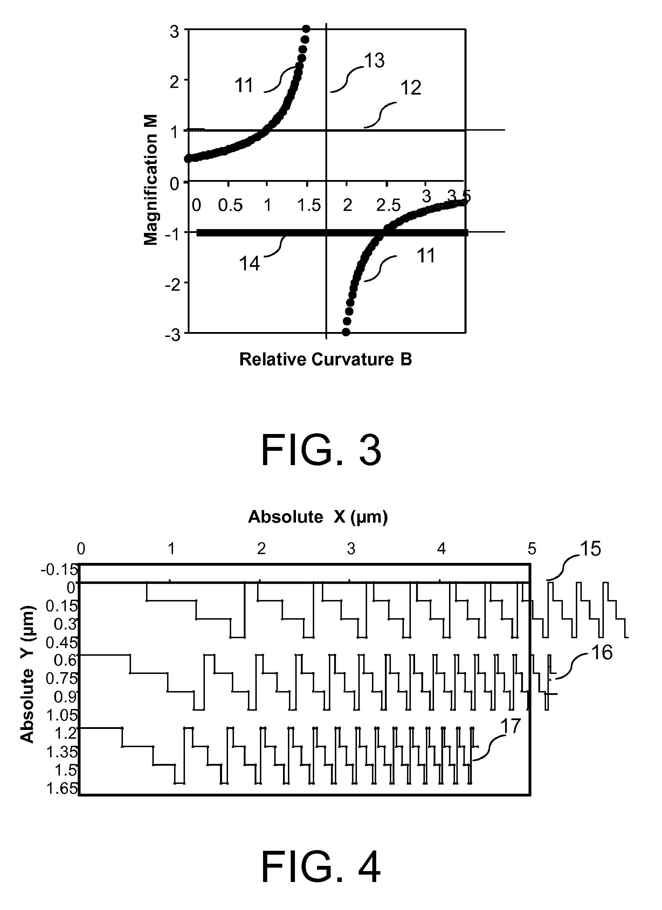

The approximate curvature B, i.e. the second order curvature B, of the Fresnel lens 3 in conjunction with the position of the optical spot in the silicon unit and the refractive indices of the front-end silicon (n₁ = 3.5) and the back-end silicon-dioxide (n₂ = 1.5) determines the magnification of the whole device. This is shown in Fig. 3 according to another embodiment of the invention. Fig. 3 illustrates the magnification M as a function of the relative curvature B and comprises four traces 11, 12, 13 and 14. Trace 11 shows the magnification of the whole device comprising the refractive indices of 3.5 and 1.5. Trace 12 shows the case of no refraction where the magnification amounts to 1. Trace 13 shows the case of a relative curvature of 1.75, and, finally, trace 14 shows the case of a magnification of-1 corresponding to the case of a real image.

The CMOS Fresnel lens is used in the embodiment of Fig. 3 to create a parallel output beam. For the same purpose the CMOS Fresnel lens is also used in the embodiment of Fig. 4. Fig. 4 shows cross sections of three distinct CMOS Fresnel lenses with a triple gate polysilicon stack. However, no STI region is shown here. Three traces 15, 16 and 17 corresponding to three values for the second order curvature B are illustrated in Fig. 4. Trace 16 shows the case of a relative curvature B equal to 1.75 resulting in a parallel output beam. Trace 17 shows the case of a real image of the light emitting spot above the silicon unit. In this case the relative curvature B is equal to 2.5. Finally, trace 15 shows the case of a virtual image in the silicon unit, i.e. the relative curvature B is equal to 1. The same parameters for the refractive indices and for the location of the output spot have been taken as in the embodiment of Fig. 1. In this way, the external light emission of the silicon unit is concentrated into the desired NA. In most applications the NA is typically lower than 1. This value corresponds to a value without a Fresnel lens.

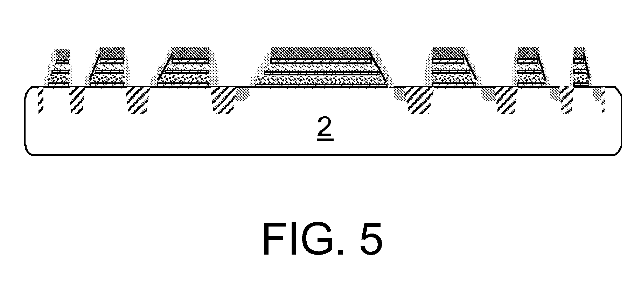

In Fig. 5 a schematic cross section of a CMOS flash memory is shown. The combination of gate polysilicon and STI regions is illustrated in Fig. 5 which also depicts a substrate 2.

In yet another embodiment the integrated CMOS Fresnel lens at an interface between the front-end and the back-end of the semiconductor device is combined with a second lens located at an interface between the back-end of the semiconductor device and air. In another embodiment this second lens corresponds to a second Fresnel lens. In yet another embodiment a one-dimensional CMOS Fresnel lens is used corresponding to line sources in the silicon unit. Also a two-dimensional CMOS Fresnel lens, i.e. a CMOS Fresnel lens in two dimensions can be used. This can be obtained with point sources in the silicon unit. In yet another embodiment of the invention arrays of point sources and/or line sources are used. Each of these sources can be equipped with an individual CMOS Fresnel lens.

The inventive idea is applicable to any kind of light emitting units. Preferably, it is applicable to a silicon unit and, most preferably, to a silicon unit comprising a CMOS structure. Further, the invention is applicable to non-coherent and coherent light emitting semiconductor units that suffer from almost total internal reflection at the interface between semiconductor and air. Such light emitting semiconductor units comprise III-V semiconductors and silicon.

Interfacial Fresnel lenses are used to improve the output efficiency of a light emitting unit while maintaining planarity of semiconductor wafers. Using polysilicon gates in combination with STI layers in CMOS technology is another embodiment of how to implement such a Fresnel lens in a standard semiconductor process. Any combination of at least two materials with different refractive indices can be used to realise such a Fresnel lens. The materials of choice are, however, not limited to polysilicon and/or silicon-dioxide.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practising the claimed invention, from a study of the drawings, the disclosure, and the appended claims. In the claims, the indefinite article "a" or "an" does not exclude a plurality. The mere fact that certain measures are recited in mutually different dependent claims does not indicate that a combination of these measures cannot be used to advantage.

A single unit may fulfil the functions of several items recited in the claims. Any reference signs in the claims should not be construed as limiting the scope.

## Claims

1. A semiconductor device for increasing output power of a light emitting unit, comprising:
- a substrate (2),
a first layer arranged at a front-end of the semiconductor device,
a second layer arranged at a back-end of the semiconductor device, and a Fresnel lens (3) arranged between the first layer and the second layer.

2. The semiconductor device according to claim 1, wherein the light emitting unit corresponds to one of a light emitting diode and an organic light emitting diode.

3. The semiconductor device according to any of the preceding claims, wherein the first layer comprises a silicon layer and the second layer comprises a silicon dioxide layer.

4. The semiconductor device according to any of the preceding claims, wherein the Fresnel lens (3) comprises a thickness of ≤ 2 µm, most preferably a thickness of µ 1µm.

5. The semiconductor device according to any of the preceding claims, wherein the Fresnel lens (3) comprises a layer of a first material (4) and a layer of a second material (5).

6. The semiconductor device according to claim 5, wherein the layer of the first material (4) comprises a first refractive index and corresponds to at least one silicon layer, most preferably to at least one polysilicon layer, and the layer of the second material (5) comprises a second refractive index being different from the first refractive index of the layer of the first material (4).

7. The semiconductor device according to claim 6, wherein at least one of the silicon layer and the polysilicon layer is adapted for providing a gate region of a CMOS structure.

8. The semiconductor device according to any of the preceding claims, further comprising outside spacers arranged adjacent to the gate region of a CMOS structure comprised by the Fresnel lens (3).

9. The semiconductor device according to any of the preceding claims, further comprising source and drain implants (6) providing source and drain regions of a CMOS structure comprised by the Fresnel lens (3).

10. The semiconductor device according to any of claims 5 to 9, wherein the layer of the second material (5) corresponds to an insulating layer provided as a shallow trench isolation layer.

11. The semiconductor device according to any of the preceding claims, further comprising at least a second lens different from the Fresnel lens (3) and arranged next to an interface between the back-end of the semiconductor device and an output of the light emitting unit.

12. The semiconductor device according to claim 11, wherein the output of the light emitting unit comprises a medium comprising a material of at least one of air and silicon dioxide.

13. The semiconductor device according to any of claims 11 and 12, wherein the second lens corresponds to a second Fresnel lens being adapted for focusing an output beam of the light emitting unit.

14. A method of manufacturing a semiconductor device having a substrate (2), for increasing output power of a light emitting unit, comprising the steps of:
- forming a first layer arranged at a front-end of the semiconductor device,
- forming a second layer arranged at a back-end of the semiconductor device, and forming a Fresnel lens (3) between the first layer and the second layer.
